Europäisches Patentamt

**European Patent Office**

Office européen des brevets

(19)

(11) Numéro de publication: **0 015 838**
**B1**

(12)

# FASCICULE DE BREVET EUROPEEN

(45) Date de publication du fascicule du brevet: **14.12.83**

(51) Int. Cl.³: **H 03 D 9/06**

(21) Numéro de dépôt: **80400286.3**

(22) Date de dépôt: **29.02.80**

(54) Mélangeur hyperfréquence à large bande.

(30) Priorité: **01.03.79 FR 7905345**

(43) Date de publication de la demande:
**17.09.80 Bulletin 80/19**

(45) Mention de la délivrance du brevet:
**14.12.83 Bulletin 83/50**

(84) Etats contractants désignés:
**DE GB IT NL**

(56) Documents cités:
**DE - B - 1 137 486**
**FR - E - 66 172**
**US - A - 4 000 469**

**MICROWAVE JOURNAL, vol. 19, no. 12, décembre 1976, Dedham, US, SCHNEIDER "Millimeter wave stripline circuits", pages 51-52**

**IEEE TRANSACTIONS ON MICROWAVE THEORY AND TECHNIQUES, vol. MTT-24, no. 11, novembre 1976. New York, US, SNELL et al. "Millimeter-wave thinfilm down converter", pages 804-806**

(73) Titulaire: **THOMSON-CSF**
**173, Boulevard Haussmann**
**F-75379 Paris Cedex 08 (FR)**

(72) Inventeur: **Blondel, Jacques**
**"THOMSON-CSF" - SCPI 173, bld Haussmann**
**F-75360 Paris Cedex 08 (FR)**
Inventeur: **Mahieu, Jean-René**
**"THOMSON-CSF" - SCPI 173, bld Haussmann**
**F-75360 Paris Cedex 08 (FR)**

(74) Mandataire: **Benoit, Monique et al,**
**THOMSON-CSF SCPI 173, Bld Haussmann**
**F-75379 Paris Cedex 08 (FR)**

(56) Documents cités
**THE BELL SYSTEM TECHNICAL JOURNAL, vol. 53, no. 6, juillet-août 1974. New York, US, SCHNEIDER et al. "Stripline down-converter with subharmonic pump", pages 1179-1183**

**IEEE TRANSACTIONS ON MICROWAVE THEORY AND TECHNIQUES, vol. MTT-19, no. 7, juillet 1971, New York, US, ARAKI et al. "A 20-GHz integrated balanced mixer", pages 638-643**

Courier Press, Leamington Spa, England.

Melangeur hyperfrequence à large bande

L'invention concerne les mélangeurs hyperfréquence à large bande passante dans lesquels la fréquence intermédiaire est basse devant la fréquence de la porteuse.

Il est connu que les mélangeurs de ce type doivent être équilibrés pour réduire l'effet du bruit de l'oscillateur local.

Il est aussi connu que la découplage des trois ondes présentes dans le mélangeur, les unes par rapport aux autres, soulève des difficultés lorsque la bande passante est large et que la fréquence intermédiaire est basse.

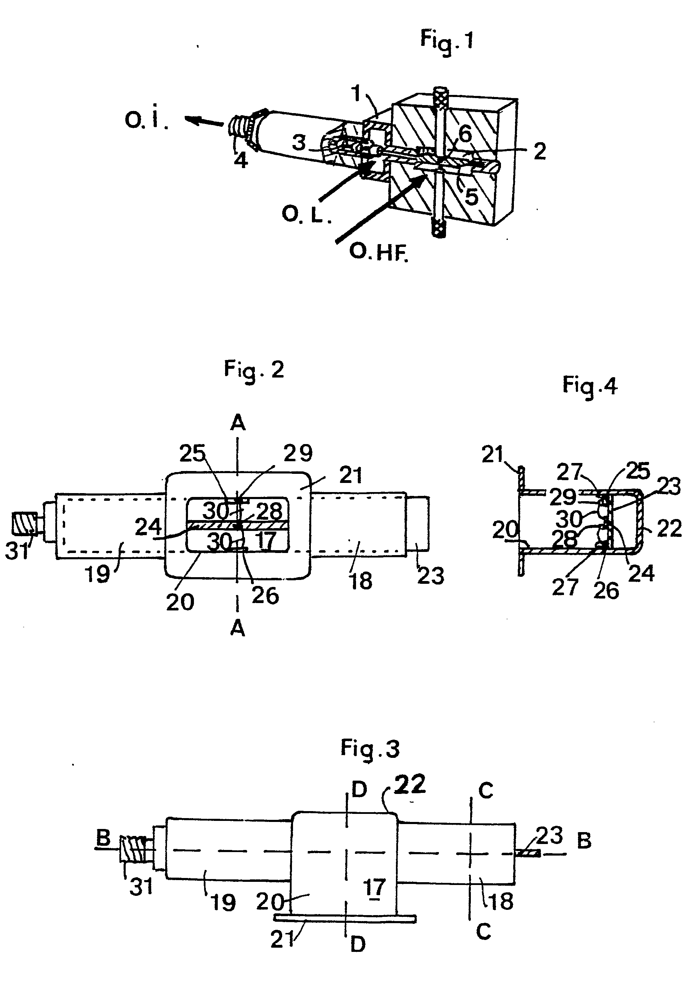

Deux solutions au problème du découplage des trois ondes ont été proposées dans les brevets américains 3,584,306 déposé le 18 Septembre 1967 et 3,638,126 déposé le 28 Janvier 1972. La synthèse des dispositions de base décrites dans ces deux brevets est représentée sur la figure 1 du catalogue de la Société SPACE KOM reproduite ici à titre d'art antérieur. Dans ce mélangeur l'oscillateur local alimente le guide d'onde 1, l'onde hyperfréquence est introduite dans la cavité 2 formée par l'extrémité d'un guide d'onde terminé par un court-circuit et l'onde à fréquence intermédiaire isolée par le filtre 3 est disponible au connecteur coaxial 4. L'onde locale est introduite dans la cavité 2 par un conducteur traversant le guide d'onde 1 et se prolongeant par un conducteur plat 5 situé dans le plan médian horizontal de la cavité 2.

Or la configuration du champ électrique engendré par le conducteur 5 est symétrique par rapport audit plan médian. La cavité 2 ne peut être excitée par l'onde locale que grâce à la présence de deux diodes 6 reliées en série entre elles dans le même sens, ayant chacune une électrode en contact avec le conducteur 5 et une électrode reliée au guide d'onde de façon à créer une dissymétrie entre les deux composantes du champ créé par le conducteur 5. Les battements entre l'onde locale et l'onde hyperfréquence apparaissent sur le conducteur 5 par suite de la non linéarité des diodes 6 et la bande latérale à fréquence inférieur est isolée en vue de constituer l'onde à fréquence intermédiaire. La structure représentée sur la figure 1 n'est compatible qu'avec des diodes en boîtier, or ce dernier limite la fréquence d'utilisation des diodes.

Il est connu dans l'art antérieur, notamment dans le brevet américain n° 4 000 469, de réaliser des mélangeurs hyperfréquences, mélangeant le signal d'une onde hyperfréquence et le signal d'une onde locale en hyperfréquence également, et délivrant en sortie un signal à une fréquence intermédiaire. Ces mélangeurs comportent des moyens pour coupler, d'une manière identique, les deux ondes hyperfréquences à une cavité mélangeuse. Dans ces moyens figurent une ligne triplaque et deux diodes de type Schottky reliant le conducteur central de la ligne aux deux conducteurs extérieurs. L'effet de cette structure est d'engendrer des produits d'intermodulation des deux ondes hyperfréquences incidentes, parmi lesquels il est exrait le signal à fréquence intermédiaire désiré. L'inconvénient présenté par ces mélangeurs est qu'ils sont sélectifs en fréquence, quoiqu'étant accordables. En conséquence, ils s'adaptent mal à une fonction de répéteurs disposés in situ, comme c'est le cas dans des systèmes où de multiples matériels large bande doivent fonctionner sans une intervention extérieure pour réglage lors d'un changement de fréquence.

Le but de l'invention est une structure de mélangeur large bande adaptée à l'utilisation des diodes en puce ou à poutre, encore connues sous le nom de "beam-lead" en terminologie anglo-saxonne.

Le melangeur selon l'invention comporte des moyens pour recevoir une onde hyperfréquence, des moyens pour recevoir une onde locale, ces moyens de réception étant reliés respectivement sur un premier et un deuxième côté de moyens mélangeurs munis d'une ligne hyperfréquence, de diodes et d'une cavité, et ces moyens mélangeurs étant reliés par un troisième côté, situé en Face du premier ou du deuxième côté, à des moyens de sortie du signal résultant du mélange, et est caractérisé en ce que les moyens de réception de l'onde hyperfréquence sont prévus pour propager cette onde un premier mode de propagation, et celui-là seulement, différent d'un deuxième mode de propagation pour lequel, et pour celui-là seulement, sont prévus les moyens de réception de l'onde locale, en ce que la cavité est traversée par un conducteur central sans contact électrique avec les parois de cette cavité, constituant, en coopération avec ces parois, la ligne hyperfréquence transmettant seulement l'une des deux ondes, et ne perturbant pas le mode de propagation de l'autre, les moyens mélangeurs autorisant ainsi la propagation simultanée en interdisant mutuellement les transitions entre les modes de propagation, assurant ainsi le découplage des moyens de réception et la production d'un signal de mélange, et en ce que les diodes sont disposées entre le conducteur central et des parois de la cavité pour produire un signal à fréquence intermédiaire à partir du signal de mélange.

Selon une variante préférée de l'invention, le même ruban conducteur est utilisé à l'introduction de l'onde délivrée par l'oscillateur local, à la mise en série des diodes mélangeuses, à la réalisation de la partie active d'un filtre basse fréquence et à la propagation de l'onde à fréquence intermédiaire.

Le mélangeur selon l'invention présente les avantages suivants:

— l'utilisation des diodes nues permet le fonctionnement aux fréquences millimétriques;
— l'utilisation de la technologie hybride simplifie le montage des diodes et, lorsqu'on utilise des diodes en puce, permet de régler les connexions avant la mise en place du substrat dansle mélangeur;
— le couplage de l'oscillateur local est réalisé en accroissant le coût de réalisation du substrat de façon négligeable, et le coût total de réalisation du mélangeur est abaissé.

L'invention est détaillée dans la description qui suit accompagnée des figures 2 à 8 données à titre purement illustratif, non limitatif.

La figure 1 déjà décrite concerne l'art antérieur.

La figure 2 représente le mélangeur selon l'invention en élévation.

La figure 3 représente une vue de dessus du mélangeur selon l'invention.

La figure 4 représente une coupe transversale de la cavité mélangeuse.

La figure 5 représente une coupe longitudinale du mélangeur selon l'invention.

La figure 6a représente une coupe du tronçon de ligne microbande d'entrée de l'onde locale.

La figure 6b représente à plus grande échelle une partie de la coupe précédente.

La figure 7 représente une vue de dessus de la variante préférée de l'invention.

Les figures 8a et 8b représentent les courbes de variation des pertes de conversion de deux mélangeurs selon l'invention.

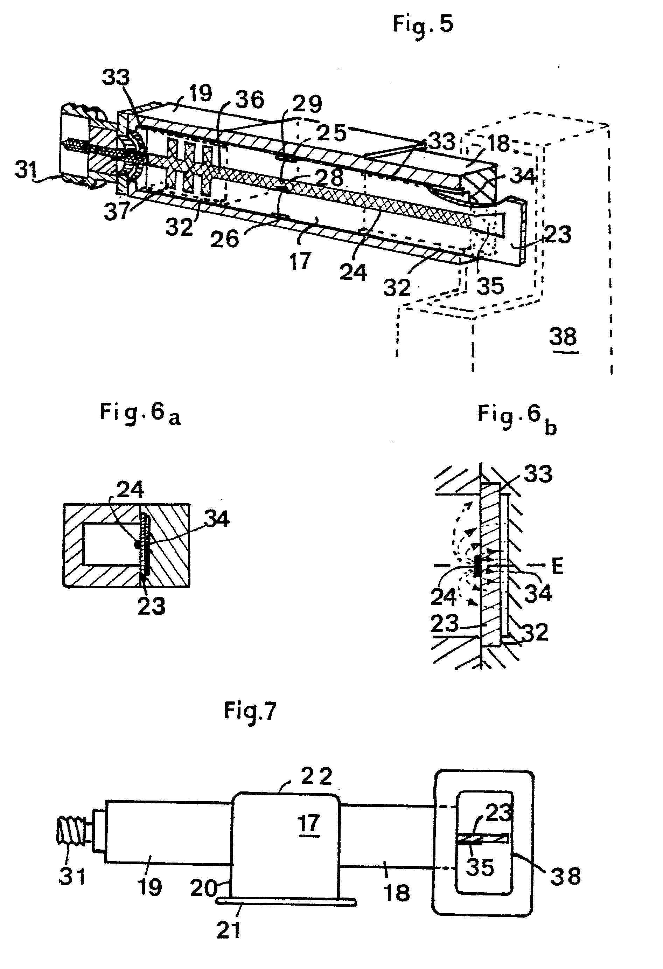

Les figures 2, 3 et 4 représentent le mélangeur selon l'invention, respectivement en élévation, en vue de dessus et en coupe transversale. Le mélangeur comporte deux boîtiers 18 et 19 situés de part et d'autre d'une cavité mélangeuse 17 constituée d'un tronçon de guide d'onde rectangulaire 20 terminé à une première extrémité par une bride standard 21 de raccordement au circuit de l'onde haute fréquence et à l'autre extrémité par un court-circuit 22. La section droite du guide d'onde 20 a ses grands côtés orientés suivant la direction longitudinale du mélangeur et ses petits côtés orientés suivant l'épaisseur. Un substrat isolant 23, par exemple en silice fondue, perpendiculaire au guide 20 et traversant les boîtiers 18 et 19, porte un ruban conducteur 24, obtenu par métallisation, partageant en son milieu la section droite du guide 20 en passant par le milieu des petits côtés. Le substrat 23 porte aussi deux métallisations 25 et 26 rectangulaires, symétriques l'une de l'autre par rapport à 24, servant de contact avec la paroi latérale du guide au milieu d'un grand côté grâce chaque fois à une goutte de colle conductrice 27, déposée après la mise en place du substrat 23, ainsi que cela apparât sur la figure 4 représentant une coupe de la cavité mélangeuse par un plan de trace AA sur la figure 2. La figure 4 illustre la mise en oeuvre de deux diodes 28 et 29 en puce collées sur 24 et 25 du côté de leur cathode et reliées en série au moyen de deux fils thermocompressés 30. Le premier de ces fils relie l'anode de la diode 29 au ruban 24 et le second relie l'anode de la diode 28 à la métallisation 26. Lorsqu'on utilise des diodes en poutres, celles-ci sont directement fixées par thermocompression sur les métallisations 25 et 26 d'une part et sur le ruban 24 d'autre part. Le mélangeur porte une microfiche coaxiale 31 sur l'une de ses faces terminales. Sur la figure 3, BB représente la trace du plan de la figure 5 et CC et DD représentent respectivement les traces des plans des figures 4 et 6.

La figure 5 représente une vue en perspective du mélangeur selon l'invention coupé suivant un plan vertical passant juste en avant du substrat 23. Le substrat 23 traverse les boîtiers 18 et 19 dans le sens longitudinal en s'appuyant sur les butées 32 et 33 qui le maintiennent à faible distance de la paroi 34. Le ruban 24 et la paroi 34 séparés par le substrat 23 constituent un premier tronçon de ligne microbande dans le boîtier 18 se terminant par une antenne 35 et dans le boîtier 19 un deuxième tronçon 36 relié à l'entrée d'un filtre passe-bas 37. L'antenne 35 et le guide d'onde 38 couplé à l'oscillateur local constituent une transition qui a été décrite dans le brevet français 2.229.147 déposé le 7 Mai 1973 par la demanderesse et à ce titre ne font pas partie de l'invention.

Les figures 6a et 6b représentent une coupe du boîtier 18 selon le plan de trace CC sur la figure 3. La figure 6a représente la position réciproque de la métallisation 24 et de la paroi 34 du boîtier qui se trouve très proche du dos du substrat 23. La figure 6b exécutée à plus grande échelle que la figure précédente représente le détail des butées 32 et 33 ainsi que la disposition des lignes de champ électrique symétrique par rapport à un plan de trace EE perpendiculaire au substrat et passant par le milieu du ruban 24.

La figure 7 représente une vue de dessus de la variante préférée de l'invention. Les éléments déjà décrits dans ce qui précède ont été reportés sur la figure 7 avec les mêmes repères:
le guide d'onde 20 fermé par le plan de courtcircuit 22 et limité par la bride 21 formant la cavité 17;
les boîtiers 18 et 19;
la microfiche coaxiale 31.
Le guide 38 d'alimentation en onde locale, est représenté tourné vers le haut en vue de faire apparaître le substrat 23 venant à proximité immédiate de la paroi du guide d'onde 38. L'épanouissement 35 du ruban 24 forme une transition à large bande entre le guide 38 dans lequel il plonge et la microbande constituée par le ruban 24, le substrat 23 et la paroi 34 du boîtier 18 contigüe au substrat 23.

Le fonctionnement du mélangeur selon l'invention est possible en réception et en émission. Dans le premier cas, une onde à fréquence $F_o$ pénètre dans la cavité 17 par le guide 20 et un oscillateur local, non représenté, envoie une onde locale à fréquence $F_{oL}$ dans le guide 38. L'onde locale se propage dans le tronçon de ligne microbande contenu dans le boîtier 18 suivant un mode TEM dont la direction du champ électrique, représentée sur la figure 6b, est orthogonale à celle du champ électrique dans la cavité 17: il ne peut donc y avoir couplage direct de la microbande à la cavité 17. L'onde locale se propage ensuite le long du ruban 24 situé à égale distance des deux parois de la cavité prolongeant les grandes faces du guide d'onde 20. Le champ électrique créé par l'onde locale est parallèle à celui de l'onde à fréquence $F_o$ mais orienté dans le même sens que lui sur une demi-hauteur de la cavité 17 et en sens opposé sur l'autre demi-hauteur. Les diodes 28 et 29 reliées dans le même sens court-circuitent l'une des composantes du champ électrique de l'onde locale et permettent à l'autre composante d'exciter une onde à fréquence $F_{oL}$ dans la cavité 17. Les deux ondes présentes à fréquence $F_o$ et $F_{oL}$ peuvent donc battre et les diodes 28 et 29 font apparaître deux composantes l'une à fréquence $F_o + F_{oL}$ et l'autre à fréquence $F_o - F_{oL}$. La composante à fréquence $F_o + F_{oL}$ ne peut traverser ni le filtre passe-bas 37 ni la transition microbande-guide d'onde car elle est dans les deux cas en dehors de la bande passante. La composante à fréquence $F_o - F_{oL} = F_i$ située dans la bande passante du filtre 37 est transmise par ce dernier à la microfiche coaxiale 31.

Dans le fonctionnement en émission une onde à fréquence $F_i$ est introduite . dans le mélangeur par la micro-fiche 31. De façon similaire à ce qui a été déjà dit, la propagation de l'onde à fréquence intermédiaire dans le tronçon de microbande 36 crée un champ selon un mode TEM orthogonal au champ dans la cavité. L'onde locale produit dans la microbande contenue dans le boîtier 19 un champ selon un mode TEM lui aussi orthogonal au champ dans la cavité 17. Les ondes à fréquence locale et intermédiaire se combinent dans la portion du ruban 24 traversant la cavité 17 par suite de la présence des diodes 28 et 29 et les composantes à fréquence $F_o - F_i$ et $F_o + F_i$ se propagent dans le guide 20. De même que précédemment ces deux ondes sont découplées de l'onde intermédiaire et de l'onde locale.

Dans les deux fonctionnements, l'onde locale qui n'emprunte que des circuits à faible perte d'insertion et à large bande transmet sensiblement toute la puissance de l'oscillateur local à la cavité 17. Dans ces conditions, les pertes de conversion sont faibles: la puissance de l'oscillateur local nécessaire est limitée, la bande passante est large et cependant le découplage des ondes entre elles est excellent bien que la fréquence intermédiaire soit faible devant celle de l'onde haute fréquence.

A titre d'exemple illustratif, la demanderesse réalise un mélangeur selon la variante préférée fonctionnant dans la bande de fréquence comprise entre 33 et 39 GHz. Ce mélangeur comporte deux tronçons de guide d'onde référencé RG 97/U orientés à angle droit. Le substrat 23 à une épaisseur égale à 0,3 millimètre, une longueur égale à 20 millimètres et une largeur égale à 2,84 millimètres. Le ruban 24 a une épaisseur égale à 2 micromètres et une largeur égale à 0,6 millimètre.

Les métallisations 25 et 26 ont une largeur égale à 0,6 millimètre et une longueur égale à 1 millimètre.

Les diodes 28 et 29 utilisées sont du type à poutre de référence DC 1308 commercialisées par la Société A.E.I. en ANGLETERRE.

La puissance de l'onde à fréquence $F_{oL}$ nécessaire est égale à 13 dBm.

La fréquence de coupure du filtre passe-bas est égale à 10 GHz.

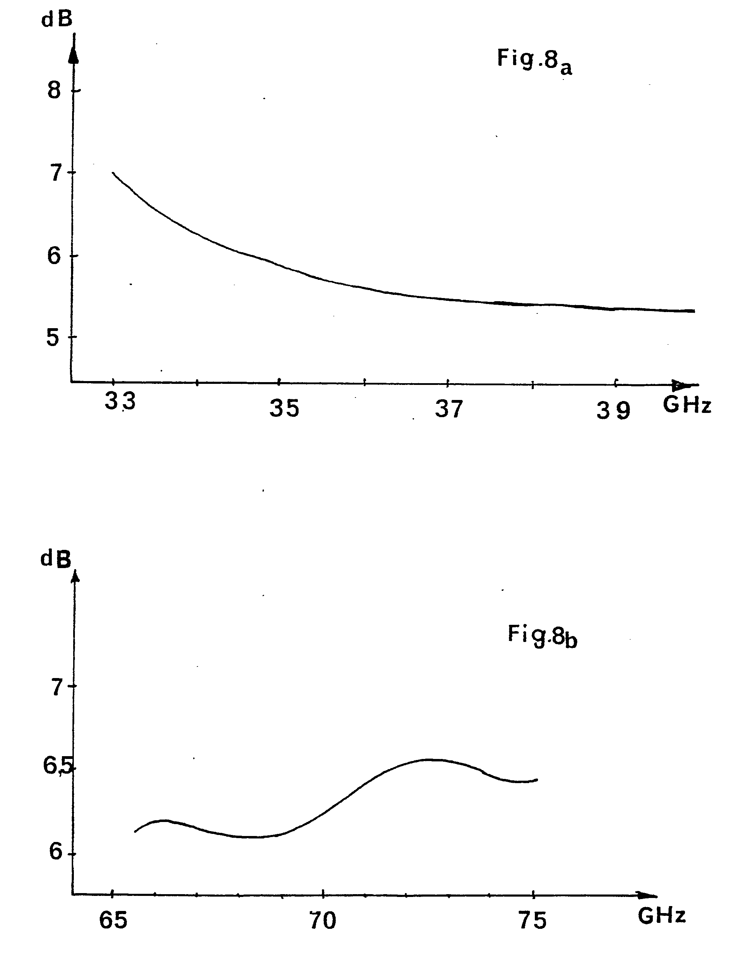

Les pertes de conversion varient dans la bande suivant la courbe représentée sur la figure 8a.

Le découplage entre l'onde à fréquence intermédiaire et l'onde haute fréquence est au moins égale à 20 db.

La demanderesse réalise dans la bande 65—75 GHz un mélangeur comportant deux tronçons de guide d'onde RG 99/U et un substrat 23 d'épaisseur égale à 0,15 millimètre, de longueur égale à 14,5 millimètres et de largeur égale à 1,5 millimètre.

Le ruban 24 porté par le substrat a une largeur de 0,3 millimètre et les métallisations 25 et 26 ont une longueur de 0,5 millimètre et une largeur de 0,3 millimètre. Les diodes 28 et 29 utilisées sont des puces développées par la Société THOMSON—CSF.

La figure 8b représente la variation des pertes de conversion dans la bande de fréquences 65—75 GHz.

**Revendications**

1. Mélangeur hyperfréquence large bande comportant des moyens (21) pour recevoir une onde hyperfréquence, des moyens (18, 24) pour recevoir une onde locale, ces moyens de réception étant reliés respectivement sur un premier et un deuxième côté de moyens mélangeurs munis d'une ligne hyperfréquence (24), de diodes (28, 29) et d'une cavité (17) et ces moyens mélangeurs étant reliés par un troisième côté, situé en face du premier ou du deuxième côté, à des moyens (19, 24) de sortie du signal résultant du mélange, caractérisé en ce que les moyens de réception de l'onde hyperfréquence sont prévus pour propager cette onde selon un premier mode de propagation (TE), et celui-là seulement, différent d'un deuxième mode de propagation (TEM) pour lequel, et pour celui-là seulement, sont prévus les moyens de réception de l'onde locale, en ce que la cavité (17) est traversée par un conducteur central (24) sans contact électrique avec les parois de cette cavité, constituant, en coopération avec ces parois, la ligne hyperfréquence transmettant seulement l'une des deux ondes, et ne perturbant pas le mode de propagation de l'autre, les moyens mélangeurs autorisant ainsi la propagation simultanée en interdisant mutuellement les transitions entre les modes de propagation, assurant ainsi le découplage des moyens de réception et la production d'un signal de mélange, et en ce que les diodes sont disposées entre le conducteur central et des parois de la cavité pour produire un signal à fréquence intermédiaire à partir du signal de mélange.

2. Mélangeur selon la revendication 1, caractérisé en ce que:

la cavité (17) est une cavité parallélépipédique à trois faces ouvertes, qui comporte une paroi (22) constituée par la face de la cavité opposée à une première face ouverte, et deux parois, connexes à la première en vis-à-vis prolongeant des faces de deux cylindres (18—19) parallélépipédiques situés de part et d'autre de la cavité, en regard des deux autres faces ouvertes;

le conducteur central de la cavité est constitué par un ruban (24) conducteur supporté par une languette (23) plane diélectrique et se prolongeant de part et d'autre de la cavité dans les deux cylindres où il forme deux tronçons de ligne en coopération avec les parois (34) de ces cylindres;

un des tronçons (18, 24, 34) constitue le moyen de réception de l'onde locale selon un mode de propagation (TEM), l'autre constituant le moyen de sortie;

les deux parois en vis-à-vis de la cavité sont perpendiculaires au ruban (24) et parallèles au grand côté d'un guide d'onde (21) relié à la cavité en regard de la première face ouverte et constituant les moyens de réception de l'onde hyperfréquence selon un autre mode de propagation (TE).

3. Mélangeur selon la revendication 2, caractérisé en ce que les diodes (28, 29) sont des diodes en puce connectées directement par leur cathode à des métallisations (24 et 25) réalisées sur la languette (23) et reliées par leur anode par deux fils thermocompressés (30) à d'autres métallisations (24—26) de la languette, ces métallisations étant prévues pour permettre le montage de ces diodes entre le conducteur central et les parois en vis-à-vis.

4. Mélangeur selon l'une quelconque des revendications 1 ou 2, caractérisé en ce que les diodes sont des diodes en poutre directement fixées par thermocompression sur le ruban (24) d'une part et d'autre part, sur des métallisations (25—26) placées sur la languette et connectées aux faces en vis-à-vis de la cavité.

5. Mélangeur selon l'une quelconque des revendications 2 à 4, caractérisé en ce que le conducteur central (24) du tronçon (18) constituant le moyen de réception de l'onde locale est terminé par un épanouissement (35) plongeant dans un guide d'onde (38) couplé à un oscillateur local et formant une transition de mode adaptée dans une large bande de fréquence.

6. Mélangeur selon l'une quelconque des revendications 2 à 5, caractérisé en ce que le conducteur central (36) du tronçon (19) constituant le moyen de sortie comporte un filtre passe-bas (37).

**Patentansprüche**

1. Mikrowellen-Breitbandmischer, mit einer Einrichtung (21) zum Empfangen von Mikrowellen, einer Einrichtung (18, 24) zum Empfangen einer lokalen Schwingung, wobei diese Empfangseinrichtungen an die erste Seite bzw. an die zweite Seite einer Mischereinrichtung angeschlossen sind, die mit einer Mikrowellenleitung (24), Dioden (28, 29) und einem Hohlraum (17) versehen ist, wobei diese Mischereinrichtung ferner auf einer dritten Seite, die der ersten oder der zweiten Seite zugewendet ist, an eine Ausgabeeinrichtung (19, 24) zum Ausgeben des durch Mischung erhaltenen Signals angeschlossen ist, dadurch gekennzeichnet, daß die Einrichtung zum Empfangen der Mikrowellen derart vorgesehen ist, daß sie nur einen einzigen Ausbreitungsmode (TE) einer Welle zuläßt, welcher versc hieden ist von einem zweiten Ausbreitungsmode (TEM), für den allein die Einrichtung zum Empfangen der lokalen Schwingung vorgesehen ist, daß der Hohlraum (17) von einem zentralen Leiter (24) ohne elektrischen Kontakt mit den Wänden dieses Hohlraums durchquert wird, welcher im Zusammenwirken mit diesen Wänden die Mikrowellenleitung bildet, welche nur eine der beiden Wellen durchläßt und den Ausbreitungsmode der anderen Welle nicht stört, wobei die Mischereinrichtung auf diese Weise die gleichzeitige Ausbreitung zuläßt, jedoch gegenseitige Übergänge zwischen den Ausbreitungsmoden unterbindet und auf diese Weise die Entkopplung der Empfangseinrichtungen sowie die Erzeugung eines Mischsignals gewährleistet, und daß die Dioden zwischen dem zentralen Leiter und den Wänden des Hohlraums angeordnet sind, um ein Zwischenfrequenzsignal aus dem Mischsignal zu erzeugen.

2. Mischer nach Anspruch 1, dadurch gekennzeichnet, daß:

der Hohlraum (17) ein quaderförmiger Hohlraum mit drei offenen Seiten ist, welcher eine Wandung (22) umfaßt, die durch diejenige Fläche des Hohlraums gebildet ist, welche einer ersten offenen Seite gegenüberliegt, und zwei Wandungen aufweist, die mit der ersten zusammenhängen, einander zugewendet sind und die Flächen von zwei quaderförmigen Zylindern (18—19) verlängern, die auf den beiden Seiten des Hohlraums gegenüber den zwei anderen offenen Flächen angeordnet sind;

der zentrale Leiter des Hohlraums aus einem leitenden Streifen (24) gebildet ist, der von einer ebenen dielektrischen Scheibe (23) getragen ist und sich auf den beiden Seiten des Hohlraums

9

**O O15 838**

10

in die beiden Zylinder hinein verlängert, wo er zwei Leitungsabschnitte bildet, die mit den Wandungen (34) dieser Zylinder zusammenwirken;

einer der Abschnitte (18, 24, 34) die Einrichtung zum Empfangen der lokalen Schwingung mit dem einen Ausbreitungsmode (TEM) bildet, während der andere die Ausgabeeinrichtung bildet;

die zwei einander zugewandten Wandungen des Hohlraums senkrecht zu dem Streifen (24) und parallel zur Haputseite eines Wellenleiters (21) sind, welcher an den Hohlraum gegenüber der ersten offenen Seite angeschlossen ist und die Einrichtung zum Empfangen der Mikrowelle mit dem anderen Ausbreitungsmode (TE) bildet.

3. Mischer nach Anspruch 2, dadurch gekennzeichnet, daß die Dioden (28, 29) Chip-Bauelemente sind, die direkt an ihrer Kathode mit Metallisierungen (24 und 25) verbunden sind, welche auf der Scheibe (23) gebildet sind, und an ihrer Anode über zwei thermokomprimierte Drähte (30) mit weiteren Metallisierungen (24—26) der Scheibe verbunden sind, wobei diese Metallisierungen derart vorgesehen sind, daß sie den Einbau dieser Dioden zwischen dem zentralen Leiter und den einander gegenüberliegenden Wänden zulassen.

4. Mischer nach Anspruch 1 oder 2, dadurch gekennzeichnet daß die Dioden vom Balkentyp sind und direkt durch Thermokompression einerseits an dem Streifen (24) und andererseits an Metallisierungen (25—26) befestigt sind, die an der Scheibe angeordnet und mit den einander gegenüberliegenden Flächen des Hohlraums verbunden sind.

5. Mischer nach einem der Ansprüche 2 bis 4, dadurch gekennzeichnet, daß der zentrale Leiter (24) des Abschnittes (18), welcher die Einrichtung zum Empfang der lokalen Schwingung bildet, durch eine Verbreiterung (35) abgeschlossen ist, welche in einen Wellenleiter (38) eintaucht, der an einen Lokaloszillator angekoppelt ist und einen in einem weiten Frequenzband angepaßten Modenübergang bildet.

6. Mischer nach einem der Ansprüche 2 bis 5, dadurch gekennzeichnet, daß der zentrale Leiter (36) des die Abgabeeinrichtung bildenden Abschnitts (19) ein Tiefpaßfilter (37) umfaßt.

**Claims**

1. Wideband microwave mixer comprising means (21) for receiving a microwave, means (18, 24) for receiving a local wave, these reception means being connected with first and second sides of mixing means, respectively, provided with a microwave line (24), diodes (28, 29) and a cavity (17), and these mixing means being connected, on a third side facing the first or second side, with output means (19, 24) of the signal resulting from the mixing, characterized in that the microwave reception means are provided for a propagation of said wave in a first propagation mode (TE) and only this mode, this mode being different from a second propagation mode (TEM) for which, and exclusively therefor, the means for receiving the local wave are provided, in that the cavity (17) is traversed by a central conductor (24) without electrically contacting the walls of this cavity and forming the microwave line in cooperation with these walls for transmitting only one of these two waves without disturbing the propagation mode of the other wave, the mixing means thus allowing a simultaneous propagation, but preventing mutual transitions between the propagation modes, thus assuring the decoupling of the reception means and the production of a mixing signal, and in that the diodes are arranged between the central conductor and the walls of the cavity to produce an intermediate frequency signal from said mixing signal.

2. Mixer in accordance with claim 1, characterized in that:

the cavity (17) is shaped as a parallelepiped having three open faces and comprising one wall (22) formed by the face of the cavity opposite a first open face, and two walls interconnected with the first wall and facing each other and forming extensions of the faces of two cylinders (18—19) shaped as parallelepipeds and located on both sides of the cavity and facing the two other open faces;

the central conductor of the cavity being formed by a conductive strip (24) carried by a dielectric plane sheet (23) and extending on both sides of the cavity into the two cylinders where it forms two line sections in cooperation with the walls (34) of these cylinders;

one of the sections (18, 24, 34) forming the means for receiving the local wave in one propagation mode (TEM), the other forming the output means;

the two facing walls of the cavity being perpendicular to the strip (24) and parallel to the major side of a wave guide (21) connected to the cavity in a position opposite the first open face and forming the means for receiving the microwave in another propagation mode (TE).

3. Mixer in accordance with claim 2, characterised in that the diodes (28, 29) are chip diodes directly connected on their cathodes to metallizations (24 and 25) formed on the sheet (23) and connected on their anodes to further metallizations (24—26) of the sheet through two thermocompressed wires (30), these metallizations being provided to allow these diodes to be mounted between the central conductor and the facing walls.

4. Mixer in accordance with any of claims 1 or 2, characterized in that the diodes are girder diodes directly secured by thermocompression on the strip (24) on the one hand and on the metallizations (25—26) on the other hand, these metallizations being located on the sheet and connected to the facing sides of the cavity.

5. Mixer in accordance with any of claims 2 to 4, characterized in that the central conductor (24) of the section (18) forming the means for receiving the local wave is terminated by an enlargement (35) plunging into a wave guide (38) coupled to a local oscillator and forming a mode transition which is adapted within a large frequency band.

6. Mixer in accordance with any of claims 2 to 5, characterized in that the central conductor (36) of the section (19) forming the output means comprises a low-pass filter (37).

Fig.1

Fig.2

Fig.4

Fig.3

Fig. 5

Fig. 6a

Fig. 6b

Fig. 7

Fig.8a

Fig.8b